Europäisches Patentamt

European Patent Office

Office européen des brevets

(11) Publication number: 0 299 674
A2

# (12) EUROPEAN PATENT APPLICATION

(21) Application number: 88306193.9

(22) Date of filing: 07.07.88

(51) Int. Cl.⁴: **H03L 7/08 , H03L 7/18**

(30) Priority: 11.07.87 GB 8716385

(43) Date of publication of application:
**18.01.89 Bulletin 89/03**

(84) Designated Contracting States:
**DE FR IT SE**

(71) Applicant: **PLESSEY OVERSEAS LIMITED
Vicarage Lane
Ilford Essex IGI 4AQ(GB)**

(72) Inventor: **Cowley, Nicholas Paul
10 Summerhouse Road
Wroughton Wiltshire(GB)**
Inventor: **McClelland, Thomas David Stephen
7 Meares Drive
Shaw Swindon Wiltshire(GB)**

(74) Representative: **Elliott, Frank Edward
The Plessey Company plc. Intellectual
Property Department Vicarage Lane
Ilford, Essex IG1 4AQ(GB)**

(54) Improvements in or relating to frequency synthesisers.

(57) A frequency synthesiser is provided including a programmable divider, a register for holding a divisor word, a reference source and a sample-and-hold phase detector, in which the register is maintained active during power-down and in which a sequence controller is provided for controlling the sequence of activations of the synthesiser on power up and supplies a substantially constant voltage, during power-down, to the output of the phase detector equivalent to the in-lock output of the detector.

*FIG./.*

## IMPROVEMENTS IN OR RELATING TO FREQUENCY SYNTHESISERS

This invention relates to frequency synthesisers of the kind having at least one local oscillator, and a phase locked loop including a programmable divider, a reference source and, at least a sample-and-hold phase detector. The invention is particularly concerned with power-down (and also power-up) arrangements for such synthesisers in order to minimise power requirements in stand-by modes.

It is well-known to provide power-down arrangements for portable equipment so as to conserve battery power when in a stand-by mode. However, when known arrangements are applied to frequency synthesisers, phase loop lock is generally lost and some time is required to re-establish loop lock. This may be of little consequence (the time required being of the order of milli seconds) with voice systems. However, for data transmission purposes, the delay is disadvantageous.

It is an object of the present invention to provide a frequency synthesiser of the kind described, in which phase loop lock is re-established very quickly on power-up, after a power-down or standby period.

According to the present invention, there is provided a frequency synthesiser of the kind described in which, in operation, a phase detector provides an output at a substantially constant voltage when phase loop lock is established, characterised in that means are provided, during a standby period, to maintain said substantially constant voltage at the output of the phase detector.

The output of the phase detector is conveniently buffered and said means may be arranged to connect a source of the substantially constant voltage to the buffered output.

The output of the phase detector may comprise a first buffer amplifier and a second buffer amplifier and a capacitor connected in parallel therewith between the first and second buffer amplifiers, the means serving to provide, on power-up, the substantially constant voltage on the capacitor.

The invention will be described further, by way of example, with reference to the accompanying drawings, in which:-

Figure 1 is block schematic circuit diagram of a frequency synthesiser in accordance with the present invention;

Figure 2 is a block schematic circuit diagram of relevant parts of a frequency synthesiser for a transceiver in accordance with the present invention; and

Figure 3a to 3d are graphical representations of system responses occasioned by a phase error.

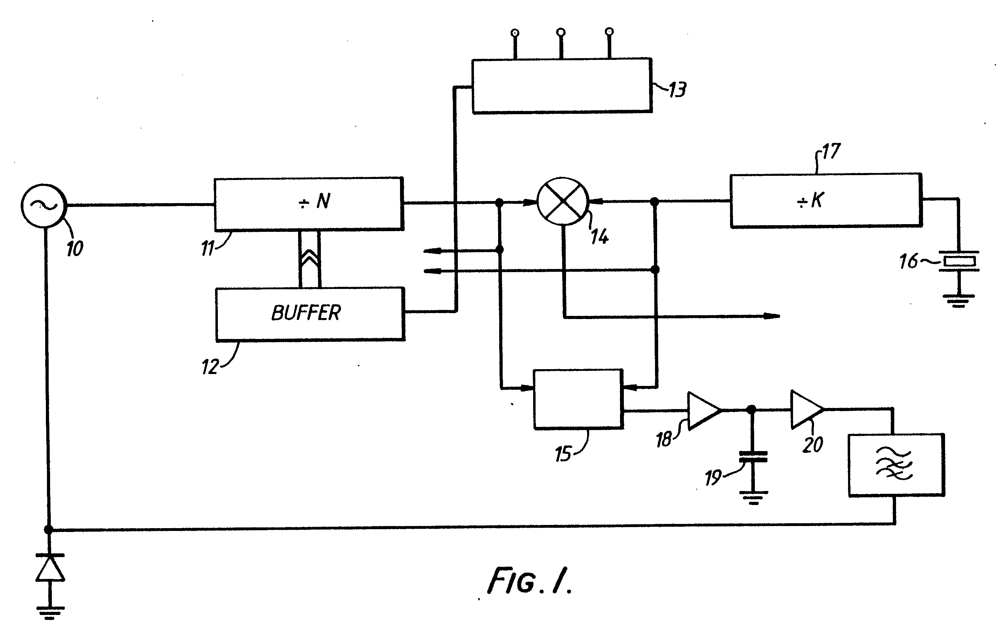

Referring firstly to Figure 1, a frequency synthesiser comprises at least one local oscillator 10 arranged to provide an output having a frequency $f_o$. The output of the local oscillator 10 is fed to a programmable divider 11 into which can be loaded an appropriate divisor from a buffer register or registers 12 in which the divisor or divisors are set by a control unit 13. The output of the programmable divider 11 has a frequency $f_{PD}$ (equals $f_{o/N}$). This output is fed to one input of a digital phase detector 14 and, in parallel, to an analogue sample-and-hold phase detector 15. A reference signal $f_{ref}$, is derived from a crystal oscillator 16, the output of which is divided by a divider 17 having a divisor K. This signal, of frequency $f_{ref}$, if fed to the detector 14 and the detector 15.

The present invention utilises the output of the sample-and-hold detector 15. This output is buffered by a first buffer amplifier 18 and then charges a capacitor 19. The voltage on the capacitor 19 is held by a second buffer amplifier 20 which in turn feeds the output signal of the detector 15 through a high pass filter 21 to a varactor 22 to control the capacitance of the local oscillator 10, whereby to change the frequency $f_o$, if necessary, thereby closing the loop.

In operation, when phase lock is attained, the voltage on the capacitor 19 becomes substantially constant and usually has a value of Vcc.2. On power-down, for stand-by operation, the dividers 11 and 17, the oscillator 16 and the oscillator or oscillators 10, and the TX power circuits are switched off. Only the buffer register 12, to retain data held therein, a means for supplying the substantially constant voltage to the capacitor 19, and incoming signal detection means remain energised.

Upon power-up e.g. upon detection of an incoming signal or when it is desired to transmit, a power up sequence controller is activated. The local oscillator 10 and the reference oscillator 16 are switched on. The trailing edge of the first pulse from the local oscillator 10 initiates a sequence in which the next $f_{ref}$ pulse is anded with a clock pulse to reset the programmable divider 11 starting the count of the word already held in the buffer register 12. The phase detectors 14 and 15 are enabled on the next $f_{pd}$ pulse and the substantially constant voltage, equal to the predetermined voltage e.g. Vcc/2, is no longer applied to the capacitor 19. It will be appreciated that, although power may be applied simultaneously to all the elements of the synthesiser, the sequence controller enables the elements in the sequence stated.

The detectors 14 and 15 detect the out-of-lock signals but the detector 15 provides a median output due to the existing voltage on the capacitor 19 and thereby correctly limits any swing of the detector output which would normally occasion large swings in the frequency of the output of the local oscillator 10.

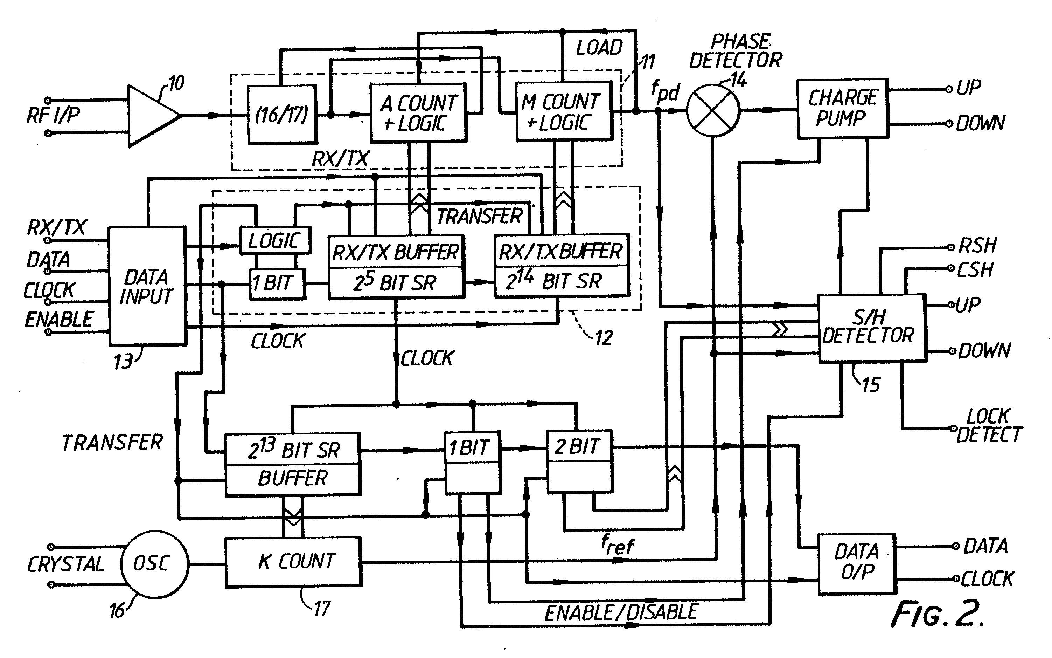

In figure 2 of the drawings, like reference numerals have been appended to circuit elements which perform similar functions to those described with reference to Figure 1. The remainder of the elements shown in such drawing are described in more detail in our copending patent applications Nos.  filed simultaneously herewith.

Figure 3a indicates the pulses seen by the phase detectors 14 and 15 on power-up. It will be seen that a phase error ø exists on the first comparison. This would normally cause a swing in output of the phase detectors to correct the phase error and would cause, normally, a pulse as shown in phantom. This would cause an opposite phase error signal and corresponding correction would occur until the correction was in the correct direction whereupon the system would move to phase lock. This is readily seen in Figure 3b in which the settling term is indicated by $t_s$.

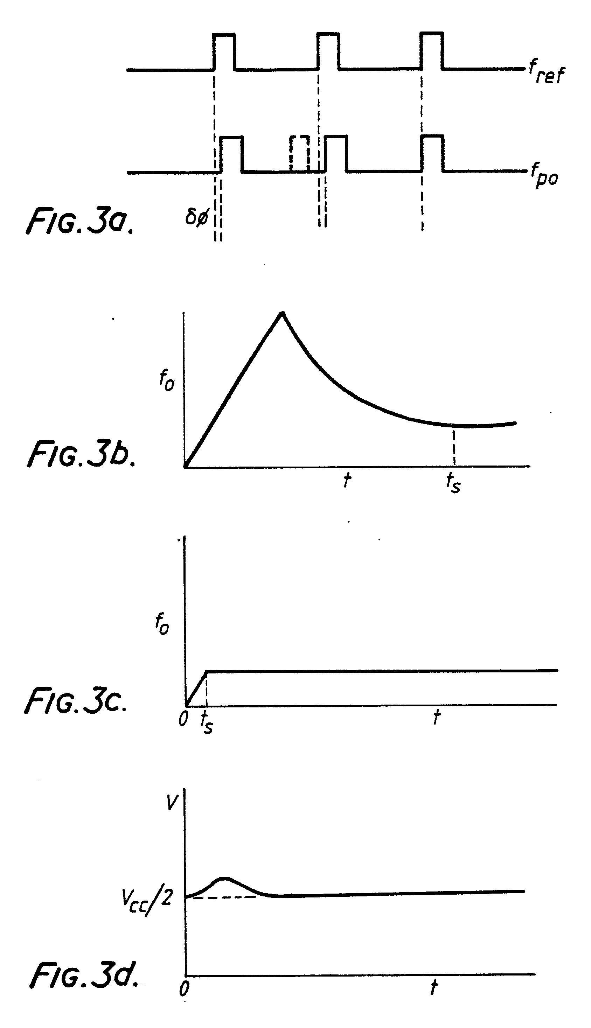

However, when power up takes place in the sequence described and the capacitor 19 sits at the substantially constant phase lock voltage eg. Vcc/2, the situation is as seen in Figure 3c wherein the phase correction signal is always in the correct direction and overshoot is avoided. The change in output of the phase detector 15 can be seen in Figure 3d.

Figure 3d indicates the change in voltage that occurs on the capacitor 19 due to the "held" voltage and the phase correction voltage.

Thus the provision of the capacitor 19, and means to apply, during power-down, the voltage thereto; a voltage source (not shown), ensures that the system always responds unindirectionally towards phase lock and overshoot and consequently long settling time is avoided.

## Claims

1. A frequency synthesiser having a phase locked loop including a programmable divider to which the output of a local oscillator may be fed, a reference source and, at least, a sample-and-hold phase detector which, in operation, provides an output at a substantially constant voltage when phase loop lock is established, a register for holding a divisor for use in the programmable divider and a sequence controller for controlling the power up sequence after a stand by period, characterised in that the register is maintained active during a stand by period, and in that, during power-down the a means is arranged to apply the substantially constant voltage at the output of the detector.

2. A synthesiser is claimed in claim 1 wherein the sequence controller is arranged, on power up, to reset the count of the programmable divider in synchronism with the output of the reference source.

3. A synthesiser as claimed in claim 1 or 2 wherein the phase detector is enabled by the sequence controller in synchronism with the output of the programmable divider.

4. A frequency divider substantially as hereinbefore described with reference to and illustrated in the accompanying drawings.

FIG. 1.

EP 0 299 674 A2

FIG. 2.

EP 0 299 674 A2

$f_{ref}$

$f_{po}$

FIG.3a.

$\delta\phi$

FIG.3b.

$f_0$

$t$     $t_s$

FIG.3c.

$f_0$

$0$ $t_s$     $t$

FIG.3d.

$V$

$V_{cc}/2$

$0$     $t$